# EUROPEAN PATENT APPLICATION

(11) **EP 4 166 687 A1**
(43) Date of publication of application: **19.04.2023**
(21) Application number: 22201737.8
(22) Date of filing: 14.10.2022
(51) Int. Cl.: C23C 14/04, H10K 71/16

(54) **MASK ASSEMBLY, AND APPARATUS AND METHOD FOR MANUFACTURING DISPLAY APPARATUS**

(30) Priority: 15.10.2021 KR 20210137633
(71) Applicant: Samsung Display Co., Ltd., Yongin-si, Gyeonggi-do 17113 (KR)
(72) Inventor: KIM, Seil, 17113 Yongin-si (KR); KIM, Minseok, 17113 Yongin-si (KR); PARK, Jongsung, 17113 Yongin-si (KR); YI, Sangmin, 17113 Yongin-si (KR)
(74) Representative: Marks & Clerk LLP

(57) **Abstract**

A mask assembly (500) includes: a mask frame (530) that includes an opening area (OA); a first mask (510) arranged on the mask frame (530) and that includes at least one first opening portion (511) in an area corresponding to the opening area (OA); and a second mask (520) arranged on the first mask (510) and that includes a plurality of second opening portions (521), wherein the plurality of second opening portions (521) overlap the at least one first opening portion (511) in a direction perpendicular to a surface of the first mask (510).

## Description

### FIELD

Embodiments of the invention relate generally to an apparatus and method and, more specifically, to a mask assembly, and an apparatus and method for manufacturing a display apparatus.

### DISCUSSION OF THE BACKGROUND

Recently, the use of display apparatuses has diversified. Also, as the thicknesses and weights of the display apparatuses have decreased, the range of applications of the display apparatuses has increased.

As the area occupied by a display area of a display apparatus has been expanded, various functions combined with or linked to the display apparatus have been added to the display apparatus. In order to increase the area and add various functions, studies have been conducted into a display apparatus having, in the display area, an area for adding various functions other than an image displaying function.

Moreover, among display apparatuses, an organic light-emitting diode display apparatus may include a pixel electrode and an opposite electrode. In this case, the opposite electrode may be formed by using several methods, one of which is to allow a deposition material to pass through a mask and to be deposited on a surface targeted for deposition. In this regard, in order to improve transmittance, the opposite electrode may not be arranged in a portion of the substrate.

The above information disclosed in this Background section is only for understanding of the background of the inventive concepts, and, therefore, it may contain information that does not constitute prior art.

### SUMMARY

Inventive concepts consistent with one or more embodiments provide for a mask assembly capable of preventing residual foreign materials, and an apparatus and method for manufacturing a display apparatus.

Additional features of the inventive concepts will be set forth in the description that follows, and in part will be apparent from the description, or may be learned by practice of the inventive concepts.

According to one or more embodiments, a mask assembly includes a mask frame that includes an opening area, a first mask arranged on the mask frame and that includes at least one first opening portion in an area corresponding to the opening area, and a second mask arranged on the first mask and that includes a plurality of second opening portions, wherein the plurality of second opening portions overlaps the at least one first opening portion in a direction perpendicular to a surface of the first mask.

According to embodiment, a diameter of each of the plurality of second openings may be less than a diameter of the at least one first opening portion.

According to embodiment, the mask assembly may further include an air channel through which air flows, the air channel being between the mask frame and the first mask.

According to embodiment, the air channel may be spaced apart from at least one of the at least one first opening portion and the plurality of second opening portions.

According to embodiment, the air channel may be arranged in an area in which the mask frame is in contact with the first mask.

According to embodiment, the air channel may include a groove concave toward inside the first mask in a thickness direction.

According to embodiment, one surface of the groove may be inclined with respect to a surface of the mask frame facing the first mask.

According to embodiment, the thickness of the first mask may get thinner toward a center of the groove.

According to embodiment, the groove may overlap an outer circumference of the opening area in the direction perpendicular to the surface of the first mask.

According to embodiment, the air channel may include a plurality of holes passing through the first mask.

According to embodiment, when viewed in the direction perpendicular to the surface of the first mask, the plurality of holes may be positioned in the second mask.

According to embodiment, at least one of the plurality of holes may be arranged to overlap the outer circumference of the opening area.

According to embodiment, the air channel may include a groove and a hole, the groove being concave toward inside the first mask in a thickness direction, and the hole passing through the first mask from one surface of the groove.

According to embodiment, the air channel may include a groove concave toward inside the mask frame in a thickness direction.

According to embodiment, one side of the groove may be connected to the opening area.

According to embodiment, the thickness of the mask frame may get thinner from the groove toward the opening area.

According to one or more embodiments, an apparatus for manufacturing a display apparatus includes a mask assembly arranged to face a substrate, and a deposition source arranged to face the mask assembly, wherein the mask assembly includes a mask frame that includes an opening area, a first mask arranged on the mask frame and that includes at least one first opening portion in an area corresponding to the opening area, and a second mask arranged on the first mask and that includes a plurality of second opening portions, wherein the plurality of second opening portions overlaps the at least one first opening portion in a direction perpendicular to a surface of the first mask.

According to embodiment, the mask assembly may further include an air channel through which air flows, the air channel being between the mask frame and the first mask.

According to embodiment, the air channel may be arranged in an area in which the mask frame is in contact with the first mask.

According to embodiment, the air channel may include a groove concave toward inside the first mask in a thickness direction.

According to embodiment, the air channel may include a plurality of holes passing through the first mask.

According to one or more embodiments, a method of manufacturing a display apparatus includes arranging a display substrate in a chamber, supplying a material to be deposited into the chamber by using a deposition source arranged in the chamber, and depositing the material to be deposited on the display substrate through a mask assembly, the mask assembly being arranged to face the deposition source, wherein the mask assembly includes a mask frame that includes an opening area, a first mask arranged on the mask frame and that includes at least one first opening portion in an area corresponding to the opening area, and a second mask arranged on the first mask and that includes a plurality of second opening portions, the plurality of second opening portions overlapping the at least one first opening portion in a direction perpendicular to a surface of the first mask.

According to embodiment, the mask assembly may further include an air channel through which air flows, the air channel being between the mask frame and the first mask.

According to embodiment, the air channel may be arranged in an area in which the mask frame is in contact with the first mask.

According to embodiment, the air channel may include a groove concave toward inside the first mask in a thickness direction.

According to embodiment, the air channel may include a plurality of holes passing through the first mask.

According to the embodiment, the method may further include cleaning the mask assembly, and drying the mask assembly.

It is to be understood that both the foregoing general description and the following detailed description are illustrative and explanatory and are intended to provide further explanation of the invention as claimed.

At least some of the above and other features of the invention are set out in the claims.

### BRIEF DESCRIPTION OF THE DRAWINGS

The accompanying drawings, which are included to provide a further understanding of the invention and are incorporated in and constitute a part of this specification, illustrate illustrative embodiments of the invention, and together with the description serve to explain the inventive concepts.
FIG. 1 is a schematic perspective view of a display apparatus according to an embodiment that is constructed according to principles of the invention.
FIG. 2 is a schematic cross-sectional view of the display apparatus of FIG. 1, according to an embodiment, taken along a line I-I'.
FIG. 3 is a schematic plan view of an arrangement of subpixels and a transmission portion arranged in a first display area and a second display area of a display apparatus, according to an embodiment.
FIG. 4 is a schematic cross-sectional view of the display apparatus of FIG. 3, according to an embodiment, taken along lines II-II' and III-III'.
FIG. 5 is a cross-sectional view of an apparatus for manufacturing a display apparatus, according to an embodiment.
FIG. 6 is a perspective view of a mask assembly according to an embodiment.;
FIG. 7 is a plan view of a mask assembly according to an embodiment.
FIG. 8 is a cross-sectional view of the mask assembly of FIG. 7, taken along a line VII-VII'.
FIGS. 9 to 11 are cross-sectional views of a mask assembly similar to FIG. 8 illustrating a mask assembly, according to an embodiment.
FIGS. 12 to 16 are diagrams similar to FIG. 8 illustrating a mask assembly, according to various embodiments.
FIGS. 17 to 19 are schematic cross-sectional views of a method of manufacturing a display apparatus, according to an embodiment.

### DETAILED DESCRIPTION

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the inventive concepts disclosed herein. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing illustrative features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the x-axis, the y-axis, and the z-axis are not limited to three axes of a rectangular coordinate system, and may be interpreted in a broader sense. For example, the x-axis, the y-axis, and the z-axis may be perpendicular to one another, or may represent different directions that are not perpendicular to one another (e.g., substantially perpendicular to one another). For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of idealized embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

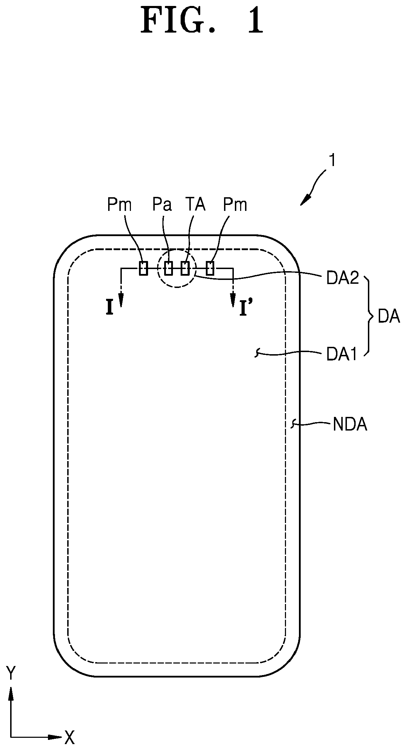

FIG. 1 is a schematic perspective view of a display apparatus 1 according to an embodiment that is constructed according to principles of the invention.

The display apparatus 1 according to an embodiment, as an apparatus for displaying a video or a still image, may be used as a display screen not only for portable electronic devices such as mobile phones, smart phones, tablet personal computers (PCs), mobile communication terminals, electronic organizers, electronic books, portable multimedia players (PMPs), navigation devices, ultra-mobile PCs (UMPCs), and the like, but also for various products such as televisions, notebooks, monitors, billboards, Internet of things (IOT), and the like. Furthermore, the display apparatus 1 according to an embodiment may be used for wearable devices such as smart watches, watch phones, glasses type displays, and head mounted displays (HMDs). Furthermore, the display apparatus 1 according to an embodiment may be used as a display for an instrument panel for vehicles, a center information display (CID) arranged on the center fascia or dashboard of vehicles, a room mirror display in lieu of a side mirror of vehicles, or a display arranged at the rear side of a front seat as an entertainment for a rear seat of vehicles. FIG. 1 illustrates, for convenience of description, that the display apparatus 1 is used as a smart phone.

Referring to FIG. 1, a display apparatus 1 may include a display area DA and a non-display area NDA outside the display area DA. The display apparatus 1 may provide an image through an array of a plurality of pixels two-dimensionally arranged in the display area DA.

The non-display area NDA is an area that does not provide an image and may entirely surround the display area DA. A driver and the like may be arranged in the non-display area NDA, the driver and the like being configured to provide electric signals or power to display elements arranged in the display area DA. A pad, which is an area to which an electronic element or a printed circuit board may be electrically connected, may be arranged in the non-display area NDA.

The display area DA may include a first display area DA1 and a second display area DA2. Main subpixels Pm may be arranged in the first display area DA1, and auxiliary subpixels Pa may be arranged in the second display area DA2. The display apparatus 1 may provide a main image by using light emitted from the main subpixels Pm arranged in the first display area DA1 and may provide an auxiliary image by using light emitted from the auxiliary subpixels Pa arranged in the second display area DA2.

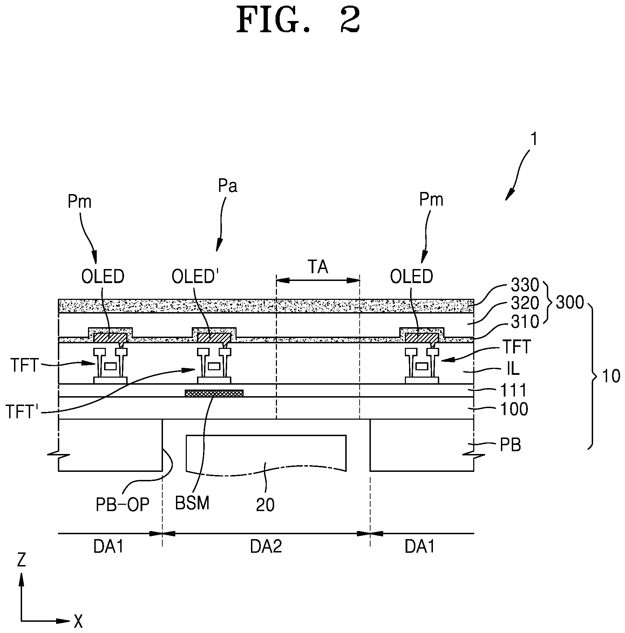

As will be described later with reference to FIG. 2, the second display area DA2 may be an area in which a component 20 (see FIG. 2), such as a sensor using infrared rays, visible light, or sound, is arranged. The second display area DA2 may include a transmission portion TA through which light and/or sound that is output from the component 20 to the outside or travels from the outside toward the component 20. In an embodiment, when light is transmitted through the second display area DA2, the light transmittance may be about 30% or higher, 50% or higher, 75% or higher, 80% or higher, 85% or higher, or 90% or higher.

An image provided in the second display area DA2 is an auxiliary image and may have a resolution lower than that of an image provided in the first display area DA1. That is, the second display area DA2 includes the transmission portion TA through which light and/or sound may pass, and the number of auxiliary subpixels Pa that may be arranged per unit area of the second display area DA2 may be less than the number of main subpixels Pm arranged per unit area of the first display area DA1.

In an embodiment, the second display area DA2 may be arranged on one side of the first display area DA1. FIG. 1 illustrates that the second display area DA2 is arranged at the upper center of the first display area DA1 and is partially surrounded by the first display area DA1. However, one or more embodiments are not limited thereto. For example, the second display area DA2 is arranged on the left or right side of the first display area DA1 so that the second display area DA2 may be between the non-display area NDA and the first display area DA1.

Hereinafter, as the display apparatus 1 according to the embodiment, an organic light-emitting display apparatus will be described as an example, but the display apparatus according to one or more embodiments is not limited thereto. In an embodiment, various display apparatus such as an inorganic light-emitting display apparatus, a quantum dot light-emitting display apparatus, etc. may be used.

FIG. 2 is a schematic cross-sectional view of the display apparatus 1 of FIG. 1, according to an embodiment, taken along a line I-I'.

Referring to FIG. 2, the display apparatus 1 may include a display panel 10 including a display element and a component 20 overlapping the display panel 10. In this case, the component 20 may be arranged below the display panel 10 and may be positioned in the second display area DA2.

The display panel 10 may include a substrate 100, thin-film transistors TFT and TFT' arranged on the substrate 100, display elements (e.g., organic light-emitting diodes OLED and OLED') electrically connected to the thin-film transistors TFT and TFT', and an encapsulation layer 300 covering the display elements. Also, the display panel 10 may further include a bottom protective film PB arranged below the substrate 100.

The substrate 100 may include glass or a polymer resin. The display substrate 100 including the polymer resin may be flexible, foldable, rollable, or bendable. The substrate 100 may have a multi-layered structure including a layer including the aforementioned polymer resin and an inorganic layer.

The thin-film transistors TFT and TFT', and the organic light-emitting diodes OLED and OLED' as display elements electrically connected to the thin-film transistors TFT and TFT' may be arranged on the substrate 100. The organic light-emitting diodes OLED and OLED' may emit red, green, or blue light.

A main subpixel Pm including the main thin-film transistorTFT and the main organic light-emitting diode OLED connected thereto may be arranged in the first display area DA1, and an auxiliary subpixel Pa including the auxiliary thin-film transistor TFT' and the auxiliary organic light-emitting diode OLED' connected thereto may be arranged in the second display area DA2.

The transmission portion TA may be positioned in the second display area DA2. The transmission portion TA may be an area through which light emitted from the component 20 and/or light directed to the component 20 may pass. In the display panel 10, the transmittance of the transmission portion TA may be about 30 % or higher, about 40 % or higher, about 50 % or higher, about 60 % or higher, about 70 % or higher, about 75 % or higher, about 80 % or higher, about 85 % or higher, or about 90 % or higher.

The component 20 may include a sensor such as a proximity sensor, an illumination sensor, or an iris sensor, or a facial recognition sensor, or a camera (or an image sensor). The component 20 may use light. For example, component 20 may emit and/or receive light in an infrared, ultraviolet, or visible band. The proximity sensor using infrared rays may detect an object arranged close to the upper surface of the display apparatus 1, and the illuminance sensor may detect the brightness of light incident on the upper surface of the display apparatus 1. Also, the iris sensor may capture an image of a person's iris arranged on the upper surface of the display apparatus 1, and the camera may receive light related to the object arranged on the upper surface of the display apparatus 1.

In an embodiment, a buffer layer 111 and an insulating layer IL may be between the substrate 100 and the organic light-emitting diodes OLED and OLED'. The insulating layer IL may include a plurality of inorganic insulating layers and/or a plurality of organic insulating layers.

In order to prevent the function of the auxiliary thin-film transistor TFT' arranged in the second display area DA2 from being deteriorated by the light passing through the transmission portion TA, a bottom electrode layer BSM may be between the substrate 100 and the buffer layer 111. The bottom electrode layer BSM may be arranged to correspond to the lower portion of the auxiliary thin-film transistor TFT'. The bottom electrode layer BSM may block external light from reaching the auxiliary subpixel Pa including the auxiliary thin-film transistor TFT' or the like. For example, the bottom electrode layer BSM may block light emitted from the component 20 from reaching the auxiliary subpixel Pa. In an embodiment, a constant voltage or signal may be applied to the bottom electrode layer BSM to prevent damage to a pixel circuit due to electrostatic discharge.

The bottom electrode layer BSM is positioned in the second display area DA2 and may include an opening overlapping the transmission portion TA. Accordingly, the bottom electrode layer BSM may not be positioned in the transmission portion TA. Also, the bottom electrode layer BSM may not be positioned in the first display area DA1.

The encapsulation layer 300 may cover the organic light-emitting diodes OLED and OLED'. The encapsulation layer 300 may include at least one organic layer and at least one inorganic layer. In an embodiment, the encapsulation layer 300 may include a first inorganic layer 310, a second inorganic layer 330, and an organic layer 320 therebetween.

Each of the first inorganic layer 310 and the second inorganic layer 330 may include one or more inorganic insulating materials from among aluminum oxide, titanium oxide, tantalum oxide, hafnium oxide, zinc oxide, silicon oxide, silicon oxynitride, and silicon nitride. The organic layer 320 may include a polymer-based material. The polymer-based material may include an acryl-based resin, an epoxy-based resin, polyimide, and polyethylene.

The bottom protective film PB may be attached to the lower portion of the substrate 100 to support and protect the substrate 100. The bottom protective film PB may include an opening PB-OP corresponding to the second display area DA2. Because the bottom protective film PB includes the opening PB-OP, the light transmittance of the second display area DA2 may be improved. The bottom protective film PB may include polyethylene terephthalate (PET) or polyimide (PI).

An area of the second display area DA2 may be greater than an area in which the component 20 is arranged. Accordingly, an area of the opening PB-OP included in the bottom protective film PB may not match the area of the second display area DA2. For example, the area of the opening PB-OP may be less than the area of the second display area DA2.

Also, a plurality of components 20 may be arranged in the second display area DA2. The plurality of components 20 may have different functions. For example, one of the plurality of components 20 may be a camera, and another thereof may be an infrared sensor.

In some implementations, elements such as an input sensing member that senses a touch input, an anti-reflective member including a polarizer and a retarder, a color filter, or a black matrix, and a transparent window may be further arranged on the display panel 10.

Moreover, though FIG. 2 illustrates that encapsulation layer 300 is used as an encapsulation member that seals the organic light-emitting diodes OLED and OLED', one or more embodiments are not limited thereto. For example, an encapsulation substrate bonded to the substrate 100 by a sealant or frit may be used as a member that seals the organic light-emitting diodes OLED and OLED'.

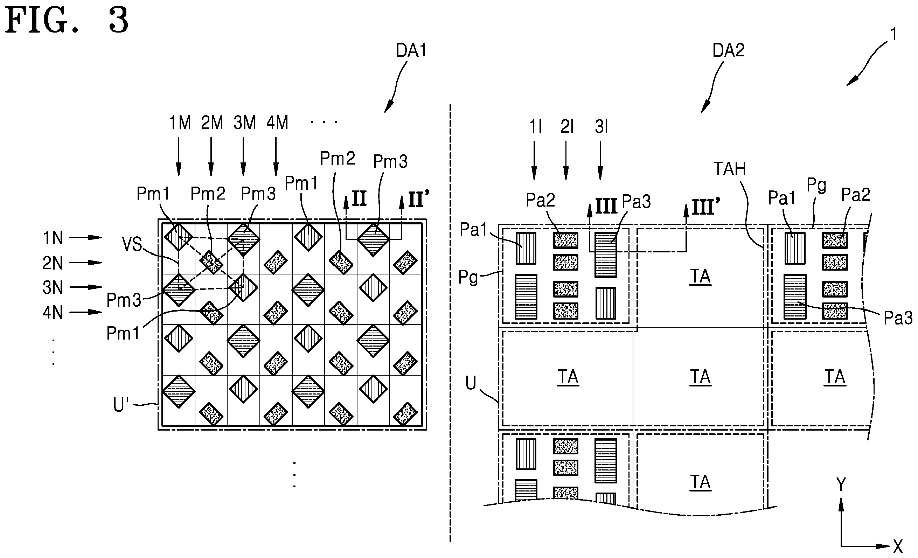

FIG. 3 is a schematic plan view of an arrangement of subpixels and a transmission portion arranged in the first display area DA1 and the second display area DA2 of the display apparatus 1, according to an embodiment.

Referring to FIG. 3, main subpixels Pm1, Pm2, and Pm3 may be arranged in the first display area DA1 of the display apparatus 1 according to an embodiment, and a pixel group Pg including auxiliary subpixels Pa1, Pa2, and Pa3, and a transmission portion TA may be arranged in the second display area DA2.

In an embodiment, the main subpixels Pm1, Pm2, and Pm3 arranged in the first display area DA1 and the auxiliary subpixels Pa1, Pa2, and Pa3 arranged in the second display area DA2 may be arranged in different structures. In the embodiments described herein, an arrangement structure of pixels is described based on an emission area of each subpixel. In this case, the emission area of the subpixel may be defined by an opening of a pixel-defining layer, which will be described below.

As illustrated in FIG. 3, the main subpixels Pm1, Pm2, and Pm3 arranged in the first display area DA1 may be arranged in a PenTile structure. The first main subpixel Pm1, the second main subpixel Pm2, and the third main subpixel Pm3 may implement different colors. For example, the first main subpixel Pm1, the second main subpixel Pm2, and the third main subpixel Pm3 may implement red, green, and blue color, respectively.

First main subpixels Pm1 and third main subpixels Pm3 may be alternately arranged in a first row 1N, second main subpixels Pm2 may be arranged in an adjacent second row 2N to be spaced apart from each other by a certain interval, third main subpixels Pm3 and first main subpixels Pm1 may be alternately arranged in an adjacent third row 3N, and second main subpixels Pm2 may be arranged in an adjacent fourth row 4N to be spaced apart from each other by a certain interval. Such a pixel arrangement is repeated up to an Nth row. In this case, the third main subpixels Pm3 and the first main subpixels Pm1 may be greater than the second main subpixels Pm2.

The first main subpixels Pm1 and the third main subpixels Pm3 arranged in the first row 1N and the second main subpixels Pm2 arranged in the second row 2N may be alternately arranged. Accordingly, first main subpixels Pm1 and third main subpixels Pm3 may be alternately arranged in a first column 1M, second main subpixels Pm2 may be arranged in an adjacent second column 2M to be spaced apart from each other by a certain interval, third main subpixels Pm3 and first main subpixels Pm1 may be alternately arranged in an adjacent third column 3M, and second main subpixels Pm2 may be arranged in an adjacent fourth column 4M to be spaced apart from each other by a certain interval. Such a pixel arrangement is repeated up to an Mth column.

Such a pixel arrangement structure may be differently expressed. From among vertices of a virtual quadrangle VS having a center point of the second main subpixel Pm2 as a center point of the virtual quadrangle VS, the first main subpixels Pm1 may be arranged at first and third vertices that face each other, and the third main subpixels Pm3 may be arranged at second and fourth vertices that are the remaining vertices. In this case, the virtual quadrangle VS may be variously modified into, for example, a rectangle, a rhombus, a square, and the like.

Such a pixel arrangement structure may be referred to as a PenTile^{™} matrix structure, and high resolution may be implemented by a small number of pixels by applying a rendering drive that represents colors by sharing adjacent pixels.

Moreover, the auxiliary subpixels Pa1, Pa2, and Pa3 arranged in the second display area DA2 may have a different shape and may be arranged in a different structure from the main subpixels Pm1, Pm2, and Pm3. The first auxiliary subpixel Pa1, the second auxiliary subpixel Pa2, and the third auxiliary subpixel Pa3 may implement different colors. For example, the first auxiliary subpixel Pa1, the second auxiliary subpixel Pa2, and the third auxiliary subpixel Pa3 may implement red, green, and blue color, respectively.

First auxiliary subpixels Pa1 and third auxiliary subpixels Pa3 may be sequentially arranged in a line in a first column 11, second auxiliary subpixels Pa2 may be sequentially arranged in a line in an adjacent second column 21, and a third auxiliary subpixel Pa3 and a first auxiliary subpixel Pa1 may be sequentially arranged in a line in an adjacent third column 31. In this case, in the first column 1l and the third column 31, the first auxiliary subpixel Pa1 and the third auxiliary subpixel Pa3 may be arranged to be opposite to each other.

The first auxiliary subpixel Pa1, the second auxiliary subpixel Pa2, and the third auxiliary subpixel Pa3 may form the pixel group Pg. Though FIG. 3 illustrates that one pixel group Pg includes 8 auxiliary subpixels Pa1, Pa2, and Pa3, one or more embodiments are not limited thereto. The number and arrangement of auxiliary subpixels Pa1, Pa2, and Pa3 included in one pixel group Pg may be variously modified.

The transmission portion TA is an area having high light transmittance because no display element is arranged therein so that the transmission portion TA may be provided as a plurality of transmission portions TA in the second display area DA2. The transmission portion TA may be alternately arranged with the pixel group Pg in an X-direction and/or a Y-direction. Alternatively, the transmission portions TA may be arranged to surround the pixel group Pg.

In the second display area DA2, an arrangement of a basic unit U in which the pixel group Pg and the transmission portion TA are bundled may be repeatedly arranged in the X-direction and the Y-direction.

In FIG. 3, the basic unit U may have a shape in which one pixel group Pg and transmission portions TA arranged therearound are bundled in a quadrangular shape. The basic unit U includes repeated shapes obtained through partitioning, and does not mean disconnection of the configuration. For example, a transmission portion TA included in one basic unit U may be formed as one body with a transmission portion TA included in an adjacent basic unit U.

In an embodiment, in the basic unit U, an area occupied by the pixel group Pg may be less than an area occupied by the transmission portion TA. For example, the area occupied by the pixel group Pg may be about 1/3 of the transmission portion TA. In other words, the area occupied by the pixel group Pg may be about 1/4 of the basic unit U, and the area occupied by the transmission portion TA may be about 3/4 of the basic unit U.

A corresponding unit U' having an area equal to an area of the basic unit U may be set in the first display area DA1. In this case, the number of main subpixels Pm1, Pm2, and Pm3 included in the corresponding unit U' may be greater than the number of auxiliary subpixels Pa1, Pa2, and Pa3 included in the basic unit U.

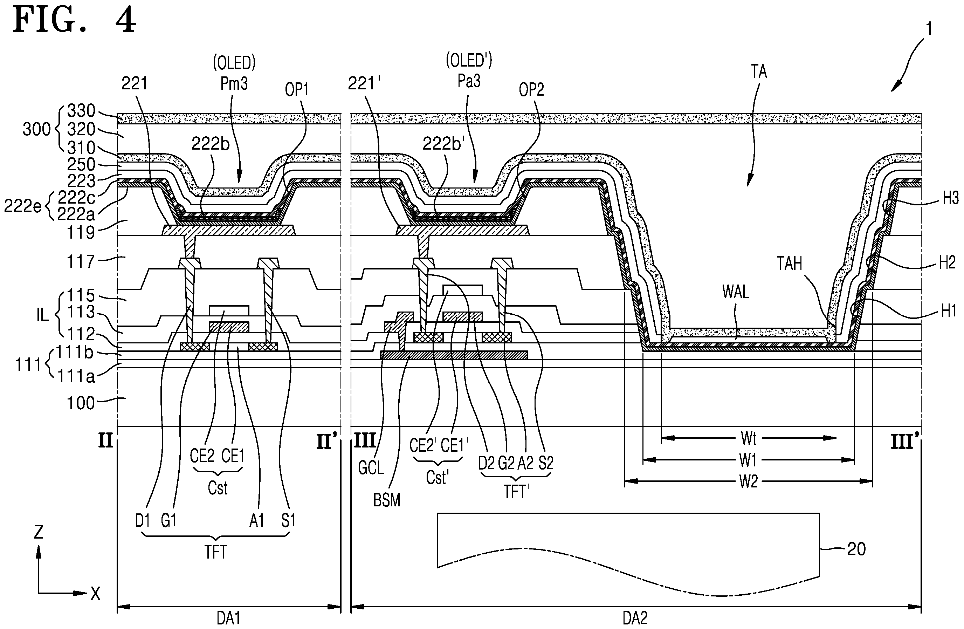

FIG. 4 is a schematic cross-sectional view of the display apparatus 1 of FIG. 3, according to an embodiment, taken along lines II-II' and III-III'.

Referring to FIG. 4, the third main subpixel Pm3 may be arranged in the first display area DA1, and the third auxiliary subpixel Pa3 and the transmission portion TA may be arranged in the second display area DA2. In this case, the third main subpixel Pm3 and the third auxiliary subpixel Pa3 may be subpixels emitting the same color. For example, the third main subpixel Pm3 and the third auxiliary subpixel Pa3 may implement blue color.

The main subpixel Pm may include a main thin-film transistor TFT, a main storage capacitor Cst, and a main organic light-emitting diode OLED. The auxiliary subpixel Pa may include an auxiliary thin-film transistor TFT', an auxiliary storage capacitor Cst', and an auxiliary organic light-emitting diode OLED'. The transmission portion TA may include an opening area TAH.

The component 20 may be arranged below the second display area DA2. The component 20 may be a camera that captures an image of an infra-red (IR) sensor that transmits/receives infrared rays.

The transmission portion TA is provided in the second display area DA2 so that light transmitted/received to/from the component 20 may pass through the transmission portion TA. For example, light emitted from the component 20 may travel in a +Z direction through the transmission portion TA, and light generated outside the display apparatus 1 and incident on the component 20 may travel in a -Z direction through the transmission portion TA. In an embodiment, the component 20 includes a plurality of image sensors so that one image sensor may be arranged to correspond to one transmission portion TA.

Hereinafter, a structure in which components included in the display apparatus 1 according to an embodiment are stacked will be described.

The substrate 100 may include glass or a polymer resin. For example, the substrate 100 may include a polymer resin such as polyethersulfone, polyacrylate, polyether imide, polyethylene naphthalate, polyethylene terephthalate, polyphenylene sulfide, polyarylate, polyimide, polycarbonate, or cellulose acetate propionate. The substrate 100 including the polymer resin may be flexible, rollable, or bendable. The substrate 100 may have a multi-layered structure including a layer including the aforementioned polymer resin and an inorganic layer.

The buffer layer 111 may be positioned on the substrate 100 to reduce or block the penetration of foreign materials, moisture, or external air from below the substrate 100 and may provide a flat surface over the substrate 100. The buffer layer 111 may include an inorganic material such as oxide or nitride, an organic material, or an organic/inorganic composite and may have a single-layered or multi-layered structure of an inorganic material and an organic material. A barrier layer that blocks the penetration of external air may be further included between the substrate 100 and the buffer layer 111. In an embodiment, the buffer layer 111 may include silicon oxide (SiOₓ) or silicon nitride (SiNₓ). The buffer layer 111 may have a structure in which a first buffer layer 111a and a second buffer layer 111b are stacked.

The bottom electrode layer BSM may be between the first buffer layer 111a and the second buffer layer 111b of the second display area DA2. In an embodiment, the bottom electrode layer BSM may be between the substrate 100 and the first buffer layer 111a. The bottom electrode layer BSM may be arranged below the auxiliary thin-film transistor TFT' to prevent the characteristics of the auxiliary thin-film transistor TFT' from being deteriorated by light emitted from the component 20.

Also, the bottom electrode layer BSM may be connected to a wire GCL arranged on a different layer through a contact hole and may receive a constant voltage or a signal from the wire GCL. For example, the bottom electrode layer BSM may receive a driving voltage or a scan signal. As the bottom electrode layer BSM receives a constant voltage or a signal, the probability of the occurrence of electrostatic discharge may be significantly reduced. The bottom electrode layer BSM may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu). The bottom electrode layer BSM may have a single-layered structure or multi-layered structure including the aforementioned material.

The main thin-film transistor TFT and the auxiliary thin-film transistor TFT' may be arranged on the buffer layer 111. The main thin-film transistor TFT may include a first semiconductor layer A1, a first gate electrode G1, a first source electrode S1, and a first drain electrode D1, and the auxiliary thin-film transistor TFT' may include a second semiconductor layer A2, a second gate electrode G2, a second source electrode S2, and a second drain electrode D2. The main thin-film transistor TFT may be connected to the main organic light-emitting diode OLED of the first display area DA1 and configured to drive the main organic light-emitting diode OLED. The auxiliary thin-film transistor TFT' may be connected to the auxiliary organic light-emitting diode OLED' of the second display area DA2 and configured to drive the auxiliary organic light-emitting diode OLED'.

The first semiconductor layer A1 and the second semiconductor layer A2 may be arranged on the buffer layer 111 and may each include polysilicon. In an embodiment, the first semiconductor layer A1 and the second semiconductor layer A2 may each include amorphous silicon. Alternatively, the first semiconductor layer A1 and the second semiconductor layer A2 may each include an oxide of at least one material selected from indium (In), gallium (Ga), stannum (Sn), zirconium (Zr), vanadium (V), hafnium (Hf), cadmium (Cd), germanium (Ge), Cr, Ti, and zinc (Zn). The first semiconductor layer A1 and the second semiconductor layer A2 may each include a channel region, and a source region and a drain region doped with impurities.

The second semiconductor layer A2 of the auxiliary thin-film transistor TFT' may overlap the bottom electrode layer BSM with the second buffer layer 111b therebetween. According to an embodiment, a width of the second semiconductor layer A2 may be less than a width of the bottom electrode layer BSM. Therefore, when projected in a direction perpendicular to the substrate 100, the second semiconductor layer A2 may entirely overlap the bottom electrode layer BSM.

A first gate insulating layer 112 may cover the first semiconductor layer A1 and the second semiconductor layer A2. The first gate insulating layer 112 may include an inorganic insulating material, such as silicon oxide (SiO₂), SiNₓ, silicon oxynitride (SiON), aluminum oxide (Al₂O₃), titanium oxide (TiO₂), tantalum oxide (Ta₂O₅), hafnium oxide (HfO₂), or zinc oxide (ZnO₂). The first gate insulating layer 112 may include a single layer or multiple layers including the aforementioned inorganic insulating material.

The first gate electrode G1 and the second gate electrode G2 may be arranged on the first gate insulating layer 112 to overlap the first semiconductor layer A1 and the second semiconductor layer A2, respectively. Each of the first gate electrode G1 and the second gate electrode G2 may include Mo, Al, Cu, Ti, or the like and may include a single layer or multiple layers. In an embodiment, the first gate electrode G1 and the second gate electrode G2 may each include a single layer including Mo.

A second gate insulating layer 113 may cover the first gate electrode G1 and the second gate electrode G2. The second gate insulating layer 113 may include an inorganic insulating material, such as SiO₂, SiNₓ, SiON, Al₂O₃, TiO₂, Ta₂O₅, HfO₂, or ZnO₂. The second gate insulating layer 113 may include a single layer or multiple layers including the aforementioned inorganic insulating material.

A first upper electrode CE2 of the main storage capacitor Cst and a second upper electrode CE2' of the auxiliary storage capacitor Cst' may be arranged on the second gate insulating layer 113.

In the first display area DA1, the first upper electrode CE2 may overlap the first gate electrode G1 arranged therebelow. The first gate electrode G1 and the first upper electrode CE2 overlapping each other with the second gate insulating layer 113 therebetween may constitute the main storage capacitor Cst. That is, the first gate electrode G1 may be a first lower electrode CE1 of the main storage capacitor Cst. However, one or more embodiments are not limited thereto. The first lower electrode CE1 and the first gate electrode G1 may be spaced apart from each other and may be provided as separate elements.

In the second display area DA2, the second upper electrode CE2' may overlap the second gate electrode G2 arranged therebelow. The second gate electrode G2 and the second upper electrode CE2' overlapping each other with the second gate insulating layer 113 therebetween may constitute the auxiliary storage capacitor Cst'. That is, the first gate electrode G1 may be a second lower electrode CE1' of the auxiliary storage capacitor Cst'. However, one or more embodiments are not limited thereto. The second lower electrode CE1' and the second gate electrode G2 may be spaced apart from each other and may be provided as separate elements.

The first upper electrode CE2 and the second upper electrode CE2' may each include Al, Pt, Pd, Ag, Mg, Au, Ni, Nd, Ir, Cr, Li, Ca, Mo, Ti, W, and/or Cu and may include a single layer or multiple layers including the aforementioned material.

An interlayer insulating layer 115 may cover the first upper electrode CE2 and the second upper electrode CE2'. The interlayer insulating layer 115 may include SiO₂, SiNₓ, SiON, Al₂O₃, TiO₂, Ta₂O₅, HfO₂, or zinc oxide (ZnO).

When the first gate insulating layer 112, the second gate insulating layer 113, and the interlayer insulating layer 115 are collectively referred to as an inorganic insulating layer IL, a structure in which the inorganic insulating layer IL is stacked on the substrate 100 may have a transmittance of about 90 % or more with respect to infrared wavelengths. For example, light having a wavelength of about 900 nm to about 1100 nm passing through the substrate 100 and the inorganic insulating layer IL may have a transmittance of about 90 %.

The source electrodes S1 and S2 and drain electrodes D1 and D2 may be arranged on the interlayer insulating layer 115. The source electrodes S1 and S2 and the drain electrodes D1 and D2 may each include a conductive material including Mo, Al, Cu, Ti, or the like and may each include a single layer or multiple layers including the aforementioned material. In an embodiment, the source electrodes S1 and S2 and the drain electrodes D1 and D2 may each have a multi-layered structure of Ti/AI/Ti.

A planarization layer 117 may cover the source electrodes S1 and S2 and the drain electrodes D1 and D2. The planarization layer 117 may have a flat upper surface so that a main pixel electrode 221 and an auxiliary pixel electrode 221' arranged thereon may be formed to be flat.

The planarization layer 117 may include a single layer or multiple layers including an organic material. The planarization layer 117 may include a general-purpose polymer such as benzocyclobutene (BCB), polyimide, hexamethyldisiloxane (HMDSO), polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or any blend thereof.

The planarization layer 117 may have a via hole that exposes one of the first source electrode S1 and the first drain electrode D1 of the main thin-film transistor TFT, and the main pixel electrode 221 may be electrically connected to the main thin-film transistor TFT in contact with the first source electrode S1 or the first drain electrode D1 through the via hole.

Also, the planarization layer 117 may have a via hole that exposes one of the second source electrode S2 and the second drain electrode D2 of the auxiliary thin-film transistor TFT', and the auxiliary pixel electrode 221' may be electrically connected to the auxiliary thin-film transistor TFT' in contact with the second source electrode S2 or the second drain electrode D2 through the via hole.

The main pixel electrode 221 and the auxiliary pixel electrode 221' may each include a conductive oxide such as indium tin oxide (ITO), indium zinc oxide (IZO), ZnO, indium oxide (In₂O₃), indium gallium oxide (IGO), or aluminum zinc oxide (AZO). In an embodiment, the main pixel electrode 221 and the auxiliary pixel electrode 221' may each include a reflective layer including Ag, Mg, Al, Pt, Pd, Au, Ni, Nd, Ir, Cr, or any compound thereof. Alternatively, the main pixel electrode 221 and the auxiliary pixel electrode 221' may each further include a layer including ITO, IZO, ZnO, or In₂O₃ above/below the aforementioned reflective layer. For example, the main pixel electrode 221 and the auxiliary pixel electrode 221' may each have a stacked structure of ITO/Ag/ITO.

A pixel-defining layer 119 may cover the edges of each of the main pixel electrode 221 and the auxiliary pixel electrode 221'. The pixel-defining layer 119 may include a first opening OP1 and a second opening OP2 that overlap the main pixel electrode 221 and the auxiliary pixel electrode 221', respectively, and define an emission area of subpixels. The pixel-defining layer 119 may increase a distance between the edges of the pixel electrodes 221 and 221' and an opposite electrode 223 above the pixel electrodes 221 and 221', thereby preventing an arc or the like from occurring at the edges of the pixel electrodes 221 and 221'. The pixel-defining layer 119 may include an organic insulating material such as polyimide, an acrylic resin, benzocyclobutene, HMDSO, a phenolic resin, and the like and may be formed by using spin coating and the like.

The planarization layer 117 and the pixel-defining layer 119 may each have a transmittance of about 90 % or more with respect to infrared wavelengths. For example, light having a wavelength of about 900 nm to about 1100 nm passing through the planarization layer 117 and the pixel-defining layer 119 may have a transmittance of about 90 %.

A main intermediate layer and an auxiliary intermediate layer may be arranged inside the first opening OP1 and the second opening OP2 of the pixel-defining layer 119 to correspond the main pixel electrode 221 and the auxiliary pixel electrode 221', respectively. In this case, the main intermediate layer may include a main light-emitting layer 222b, and the auxiliary intermediate layer may include an auxiliary light-emitting layer 222b'. The main light-emitting layer 222b and the auxiliary light-emitting layer 222b' may each include a polymer material or a low molecular weight material and may emit red, green, blue, or white light.

The main intermediate layer and/or the auxiliary intermediate layer as described above may include an organic functional layer 222e arranged above and/or below the main light-emitting layer 222b and/orthe auxiliary light-emitting layer 222b'. The organic functional layer 222e may include a first functional layer 222a and/or a second functional layer 222c. The first functional layer 222a and/or the second functional layer 222c may be omitted in some implementations of the embodiment described herein.

The first functional layer 222a may be arranged below the main light-emitting layer 222b and the auxiliary light-emitting layer 222b'. In this case, in an embodiment, the first functional layer 222a may be patterned to correspond to the first opening OP1 and the second opening OP2 like the main light-emitting layer 222b and the auxiliary light-emitting layer 222b' and may be arranged inside the first opening OP1 and the second opening OP2. Alternatively, the first functional layer 222a may be arranged to cover the surfaces of the first display area DA1 and the second display area DA2. Alternatively, the first functional layer 222a may be patterned to correspond to the first opening OP1 and the second opening OP2 and arranged inside the first opening OP1 and the second opening OP2, and may not be arranged in the transmission portion TA. Alternatively, the first functional layer 222a may be arranged to shield the second display area DA2 except for the transmission portion TA and the front surface of the first display area DA1. Hereinafter, for convenience of description, a case where the first functional layer 222a is arranged to cover the front surfaces of the first display area DA1 and the second display area DA2 will be mainly described in detail.

The first functional layer 222a may include a single layer or multiple layers including an organic material. The first functional layer 222a may include a hole transport layer (HTL) having a single-layered structure. Alternatively, the first functional layer 222a may include a hole injection layer (HIL) and an HTL. The first functional layer 222a may be formed as one body to correspond to the main subpixel Pm and the auxiliary subpixel Pa included in the first display area DA1 and the second display area DA2. Accordingly, the first functional layer 222a may be arranged to correspond to the transmission portion TA.

The second functional layer 222c may be arranged above the main light-emitting layer 222b and the auxiliary light-emitting layer 222b'. In this case, in an embodiment, the second functional layer 222c may be patterned to correspond to the first opening OP1 and the second opening OP2 like the main light-emitting layer 222b and the auxiliary light-emitting layer 222b' and may be arranged inside the first opening OP1 and the second opening OP2. Alternatively, the second functional layer 222c may be arranged to cover the front surfaces of the first display area DA1 and the second display area DA2. Alternatively, the second functional layer 222c may be patterned to correspond to the first opening OP1 and the second opening OP2 and arranged inside the first opening OP1 and the second opening OP2, and may not be arranged in the transmission portion TA. Alternatively, the second functional layer 222c may be arranged to shield the second display area DA2 except for the transmission portion TA and the front surface of the first display area DA1. Hereinafter, for convenience of description, a case where the second functional layer 222c is arranged to cover the front surfaces of the first display area DA1 and the second display area DA2 will be mainly described in detail.

The second functional layer 222c may include a single layer or multiple layers including an organic material. The second functional layer 222c may include an electron transport layer (ETL) and/or an electron injection layer (EIL). The second functional layer 222c may be formed as one body to correspond to the main subpixel Pm and the auxiliary subpixel Pa included in the first display area DA1 and the second display area DA2. Accordingly, the second functional layer 222c may be arranged to correspond to the transmission portion TA.

The opposite electrode 223 may be arranged on the second functional layer 222c. The opposite electrode 223 may include a conductive material having a low work function. For example, the opposite electrode 223 may include a (semi-)transparent layer including Ag, Mg, Al, Pt, Pd, Au, Ni, Nd, Ir, Cr, Li, Ca, or any alloy thereof. Alternatively, the opposite electrode 223 may further include a layer such as ITO, IZO, ZnO or In₂O₃ on the (semi-) transparent layer including the aforementioned material. The opposite electrode 223 may be formed as one body to correspond to the main subpixel Pm and the auxiliary subpixel Pa included in the first display area DA1 and the second display area DA2.

Layers formed in the first display area DA1 from the main pixel electrode 221 to the opposite electrode 223 may form the main organic light-emitting diode OLED, and layers formed in the second display area DA2 from the auxiliary pixel electrode 221' to the opposite electrode 223 may form the auxiliary organic light-emitting diode OLED'.

An upper layer 250 including an organic material may be formed on the opposite electrode 223. The upper layer 250 may be a layer provided to protect the opposite electrode 223 and increase light extraction efficiency. The upper layer 250 may include an organic material having a refractive index higher than that of the opposite electrode 223. Alternatively, the upper layer 250 may include a stack of layers having different refractive indexes. For example, the upper layer 250 may include a stack of a high refractive index layer/a low refractive index layer/a high refractive index layer. In this case, a refractive index of the high refractive index layer may be 1.7 or more, and a refractive index of the low refractive index layer may be 1.3 or less.

The upper layer 250 may further include lithium fluoride (LiF). Alternatively, the upper layer 250 may additionally include an inorganic insulating material such as SiO₂ or SiNₓ. Alternatively, the upper layer 250 may include an inorganic material.

In the embodiment, the opposite electrode 223 and the upper layer 250 may each include an opening area TAH corresponding to the transmission portion TA. That is, the opposite electrode 223 and the upper layer 250 may each include an opening corresponding to the transmission portion TA. In this case, a weak adhesion layer WAL may be arranged in the opening corresponding to the transmission portion TA. That is, in the transmission portion TA, the weak adhesion layer WAL may be arranged on the second functional layer 222c. This will be described below.

In an embodiment, widths of the openings forming the opening area TAH may be substantially the same. For example, a width of an opening of the opposite electrode 223 may be substantially the same as a width of the opening area TAH.

Also, in an embodiment, the first functional layer 222a, the second functional layer 222c, and the upper layer 250 may be omitted in some implementations of the embodiment described herein. In this case, the opening of the opposite electrode 223 may be the opening area TAH.

In an embodiment, the inorganic insulating layer IL, the planarization layer 117, and the pixel-defining layer 119 may respectively include a first hole H1, a second hole H2, and a third hole H3 corresponding to the transmission portion TA.

The opening area TAH corresponding to the transmission portion TA may denote that the opening area TAH overlaps the transmission portion TA. In this case, an area of the opening area TAH may be less than an area of the first hole H1 formed in the inorganic insulating layer IL. To this end, FIG. 4 illustrates that a width Wt of the opening area TAH is less than a width W1 of the first hole H1. In this case, the area of the opening area TAH and the area of the first hole H1 may be defined as an area of an opening having the smallest area.

In an embodiment, the first functional layer 222a, the second functional layer 222c, the opposite electrode 223, and the upper layer 250 may be arranged on the side surfaces of the first hole H1, the second hole H2, and the third hole H3. In an embodiment, a slope of the side surfaces of the first hole H1, the second hole H2, and the third hole H3 with respect to the upper surface of the substrate 100 may be gentler than a slope of the side surface of the opening area TAH with respect to the upper surface of the substrate 100.

When the opening area TAH is formed, it connotes that a member such as the opposite electrode 223 or the like is removed from the transmission portion TA so that the light transmittance of the transmission portion TA may be materially increased.

The main organic light-emitting diode OLED and the auxiliary organic light-emitting diode OLED' may be sealed by the encapsulation layer 300. The encapsulation layer 300 may be arranged on the upper layer 250. The encapsulation layer 300 may prevent the penetration of foreign materials or external moisture into the main organic light-emitting diode OLED and the auxiliary organic light-emitting diode OLED'.

The encapsulation layer 300 may include at least one inorganic layer and at least one organic layer. In this regard, FIG. 4 illustrates a structure in which the first inorganic layer 310, the organic layer 320, and the second inorganic layer 330 are stacked. In an embodiment, the number of organic layers, the number of inorganic layers, and a stacking order thereof may be changed.

The first inorganic layer 310 and the second inorganic layer 330 may each include one or more inorganic insulating materials such as aluminum oxide, titanium oxide, tantalum oxide, hafnium oxide, zinc oxide, silicon oxide, silicon oxynitride, and silicon nitride, and may be formed by using chemical vapor deposition (CVD) or the like. The organic layer 320 may include a polymer-based material. The polymer-based material may include a silicon-based resin, an acryl-based resin, an epoxy-based resin, polyimide, and polyethylene.

The first inorganic layer 310, the organic layer 320, and the second inorganic layer 330 may be formed as one body to cover the first display area DA1 and the second display area DA2. Accordingly, the first inorganic layer 310, the organic layer 320, and the second inorganic layer 330 may be arranged inside the opening area TAH.

Alternatively, the organic layer 320 may be formed as one body to cover the first display area DA1 and the second display area DA2, but may not be present in the transmission portion TA. In other words, the organic layer 320 may include an opening corresponding to the transmission portion TA. In this case, the first inorganic layer 310 and the second inorganic layer 330 may be in contact with each other inside the opening area TAH.

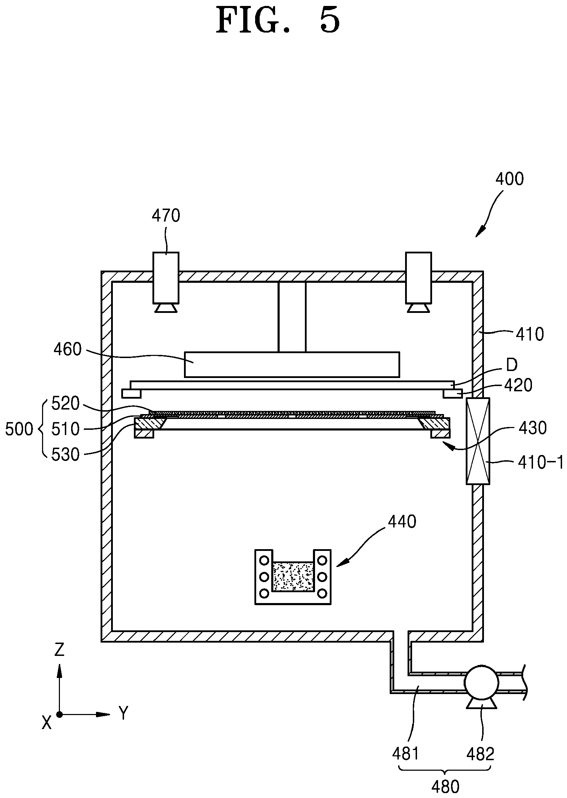

FIG. 5 is a cross-sectional view of an apparatus 400 for manufacturing a display apparatus, according to an embodiment.

Referring to FIG. 5, the display apparatus 1 described above may be manufactured by using the apparatus 400 for manufacturing the display apparatus.

The apparatus 400 for manufacturing the display apparatus may include a chamber 410, a first support portion 420, a second support portion 430, a mask assembly 500, a deposition source 440, a magnetic force portion 460, a vision portion 470, and a pressure controller 480.

The chamber 410 may have a space therein, and a portion of the chamber 410 may be opened. In this regard, a gate valve 410-1 may be provided in the opened portion of the chamber 410. In this case, the opened portion of the chamber 410 may be opened or closed according to the operation of the gate valve 410-1.

A display substrate D may be seated on and supported by the first support portion 420. In this case, the first support portion 420 may be in the form of a plate fixed inside the chamber 410. In another embodiment, the display substrate D is seated on the first support portion 420, and the first support portion 420 may be in the form of a shuttle to be linearly movable inside the chamber 410. In another embodiment, the first support portion 420 may include an electrostatic chuck or an adhesive chuck fixed to the chamber 410 or arranged inside the chamber 410 to be movable up and down inside the chamber 410. Hereinafter, for convenience of description, a case where the first support portion 420 is in the form of a plate fixed inside the chamber 410 will be mainly described in detail.

The mask assembly 500 may be seated on the second support portion 430. In this case, the second support portion 430 may be arranged inside the chamber 410. The second support portion 430 may finely adjust the position of the mask assembly 500. In this case, the second support portion 430 may include a separate driver or aligner to move the mask assembly 500 in various directions.

In another embodiment, the second support portion 430 may be in the form of a shuttle. In this case, the mask assembly 500 is seated on the second support portion 430, and the second support portion 430 may transport the mask assembly 500. For example, the second support portion 430 may move out of the chamber 410 and enter the chamber 410 from the outside of the chamber 410 after the mask assembly 500 is seated on the second support portion 430.

In the aforementioned case, the first support portion 420 and the second support portion 430 may be formed as one body. In this case, the first support portion 420 and the second support portion 430 may each include a movable shuttle. In this regard, the first support portion 420 and the second support portion 430 may have a structure in which the mask assembly 500 and the display substrate D are fixed to each other in a state in which the display substrate D is seated on the mask assembly 500, and the display substrate D and the mask assembly 500 may be linearly moved simultaneously.

However, hereinafter, for convenience of description, the shape in which the first support portion 420 and the second support portion 430 are formed to be separated from each other and arranged at different positions, and the shape in which the first support portion 420 and the second support portion 430 are arranged inside the chamber 410 will be mainly described in detail.

The deposition source 440 may be arranged to face the mask assembly 500. In this case, a material to be deposited may be accommodated in the deposition source 440, and may be heated to be evaporated or sublimated. The deposition source 440 may be arranged to be fixed inside the chamber 410 or arranged inside the chamber 410 to be linearly movable in one direction. However, hereinafter, for convenience of description, a case where the deposition source 440 is arranged to be fixed inside the chamber 410 will be mainly described in detail.

The mask assembly 500 includes a mask frame 530, a first mask 510, and a second mask 520. This will be described below.

The magnetic force portion 460 may be arranged inside the chamber 410 to face the display substrate D. In this case, the magnetic force portion 460 may apply a force to the mask assembly 500 toward the display substrate D by applying a magnetic force to the mask assembly 500. In particular, the magnetic force portion 460 may prevent the masks 510 and 520 from sagging and may bring the masks 510 and 520 close to the display substrate D. Also, the magnetic force portion 460 may maintain a uniform distance between the masks 510 and 520 and the display substrate D.

The vision portion 470 may be provided in the chamber 410 and may capture images of the positions of the display substrate D and the mask assembly 500. In this case, the vision portion 470 may include a camera that captures images of the display substrate D and the mask assembly 500. The positions of the display substrate D and the mask assembly 500 may be identified based on the images captured by the vision portion 470, and based on the images, the first support portion 420 may finely adjust the position of the display substrate D or the second support portion 430 may finely adjust the position of the mask assembly 500. However, hereinafter, a case where the second support portion 430 finely adjusts the position of the mask assembly 500 to align the positions of the display substrate D and the mask assembly 500 will be mainly described in detail.

The pressure controller 480 may be connected to the chamber 410 to control the internal pressure of the chamber 410. For example, the pressure controller 480 may adjust the internal pressure of the chamber 410 to be identical to or similar to the atmospheric pressure. Also, the pressure controller 480 may adjust the internal pressure of the chamber 410 to be identical to or similar to the vacuum state.

The pressure controller 480 may include a connection pipe 481 connected to the chamber 410 and a pump 482 provided on the connection pipe 481. In this case, according to the operation of the pump 482, external air may be introduced through the connection pipe 481, or gas inside the chamber 410 may be discharged to the outside through the connection pipe 481.

Moreover, the apparatus 400 for manufacturing the display apparatus as described above may be used to manufacture the display apparatus 1 described above. In detail, when the pressure controller 480 makes the inside of the chamber 410 identical to or similar to the atmospheric pressure, the gate valve 410-1 may operate to open the opened portion of the chamber 410.

Thereafter, the display substrate D may be inserted into the chamber 410 from the outside of the chamber 410. In this case, the display substrate D may be inserted into the chamber 410 in various manners. For example, the display substrate D may be inserted into the chamber 410 from the outside of the chamber 410 through a robot arm or the like arranged outside the chamber 410. In another embodiment, when the first support portion 420 is in the form of a shuttle, after the first support portion 420 is carried out from the inside of the chamber 410 to the outside of the chamber 410, the display substrate D may be seated on the first support portion 420 by using a separate robot arm or the like arranged outside the chamber 410, and the first support portion 420 may be inserted into the chamber 410 from the outside of the chamber 410. Hereinafter, for convenience of description, a case where the display substrate D is inserted into the chamber 410 from the outside of the chamber 410 by using the robot arm or the like arranged outside the chamber 410 will be mainly described in detail.

The mask assembly 500 may be arranged inside the chamber 410 as described above. In another embodiment, the mask assembly 500 may be inserted into the chamber 410 from the outside of the chamber 410 in an identical or similar manner to the display substrate D. However, hereinafter, for convenience of description, a case where only the display substrate D is inserted into the chamber 410 from the outside of the chamber 410 in a state in which the mask assembly 500 is arranged inside the chamber 410 will be mainly described in detail.

In the aforementioned case, in another embodiment, in a state in which the first support portion 420 and the second support portion 430 are in the form of a shuttle, after the display substrate D is fixed to the mask assembly 500, the display substrate D may be inserted into the chamber 410 from the outside of the chamber 410, as described above.

When the display substrate D is inserted into the chamber 410, the display substrate D may be seated on the first support portion 420. In this case, the vision portion 470 may capture images of the positions of the display substrate D and the mask assembly 500. In particular, the vision portion 470 may capture images of a first align mark of the display substrate D and a second align mark of the mask assembly 500.

The positions of the display substrate D and the mask assembly 500 may be identified based on the images of the first and second align marks captured as described above. In this case, the apparatus 400 for manufacturing the display apparatus is provided with a separate controller to identify the positions of the display substrate D and the mask assembly 500.

When the positions of the display substrate D and the mask assembly 500 are identified, the second support portion 430 may finely adjust the position of the mask assembly 500.

Thereafter, the deposition source 440 may operate to supply a material to be deposited toward the mask assembly 500, and the material to be deposited passing through a plurality of opening portions of the masks 510 and 520 may be deposited on the display substrate D. In this case, the pump 482 may maintain the internal pressure of the chamber 410 to be identical to or similar to the vacuum state by sucking in the gas inside the chamber 410 and discharge the gas to the outside.

In the aforementioned case, the material to be deposited may be deposited on the display substrate D through an opening portion arranged on a deposition area described above. In this case, the mask assembly 500 may provide a deposition area identical to or similar to the deposition area designed as described above.

An operation as described above may be repeatedly performed on a plurality of display substrates D. In this case, when the number of depositions on the plurality of display substrates D is equal to a preset number of depositions, the apparatus 400 for manufacturing the display apparatus stops operating, and the mask assembly 500 may be drawn out of the chamber 410.

Because the material to be deposited used during deposition may be deposited on the mask assembly 500, the mask assembly 500 may be cleaned by spraying a cleaning solution onto the mask assembly 500. In particular, in this case, when the material to be deposited is deposited on the opening portions of the masks 510 and 520, the material to be deposited is not deposited on the display substrate D as much as a pre-designed area, and thus, precise deposition may be difficult. However, as described above, such a problem may be solved by cleaning the material to be deposited adsorbed on the outer surface of the mask assembly 500 and/or the opening portions of the masks 510 and 520.

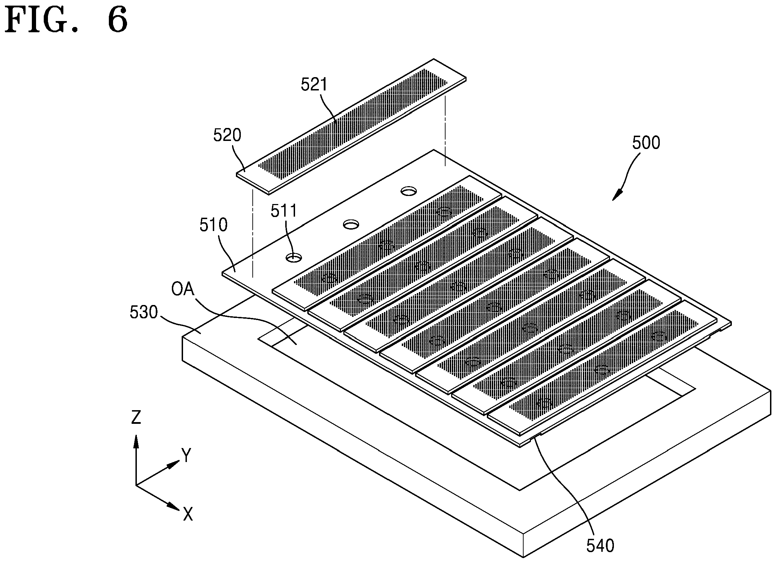

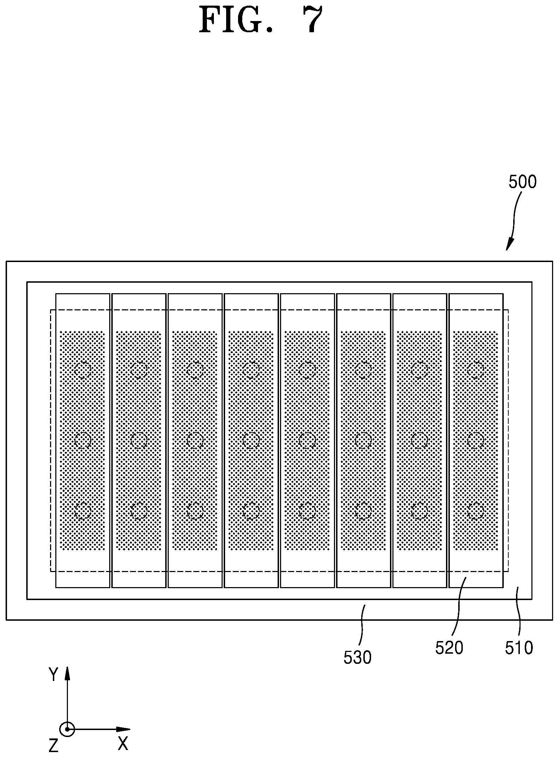

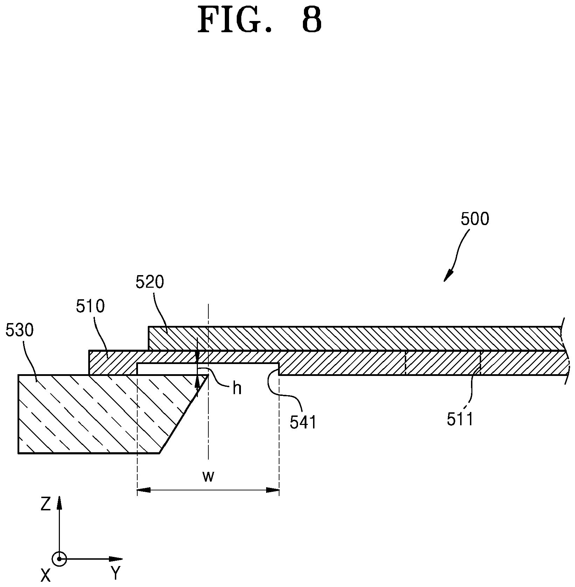

FIG. 6 is a perspective view of the mask assembly 500 according to an embodiment, FIG. 7 is a plan view of the mask assembly 500 according to an embodiment, and FIG. 8 is a cross-sectional view of the mask assembly of FIG. 7, taken along a line VII-VII'.

Referring to FIGS. 6 to 8, the mask assembly 500 may include the first mask 510, the second mask 520, and the mask frame 530.

The mask frame 530 may include an opening area OA at the center thereof. In an embodiment, the mask frame 530 may be in the form of a frame in which one opening area OA is formed at the center thereof. In another embodiment, the mask frame 530 may be in a grid shape such as a window frame including a plurality of opening areas OA. Hereinafter, for convenience of description, a case where one opening area OA is formed at the center of the mask frame 530 will be mainly described in detail.

The first mask 510 may be arranged on the mask frame 530. In detail, the first mask 510 may be arranged to cover the opening area OA of the mask frame 530. In an embodiment, the first mask 510 may have a width greater than a width of the opening area OA so that the first mask 510 may be arranged on the mask frame 530 to completely cover the opening area OA. In an embodiment, the first mask 510 may be fixed to the mask frame 530 by using welding.

The first mask 510 may include a first opening portion 511. The first opening portion 511 may be arranged to be at a position corresponding to the opening area OA of the mask frame 530, that is, in the opening area OA when viewed in a -Z direction in FIG. 6. In an embodiment, the first mask 510 may include at least one first opening portion 511, and in another embodiment, the first mask 510 may include a plurality of first opening portions 511 spaced apart from each other. Hereinafter, for convenience of description, a case where the plurality of first opening portions 511 are provided will be mainly described.

In an embodiment, the first opening portion 511 may be formed in the first mask 510 at a position corresponding to the second display area DA2 (see FIG. 1) of the display apparatus 1 described above. In detail, the first mask 510 may be a mask for depositing the material to be deposited on a plurality of display panels 10, and each of the plurality of first opening portions 511 may be formed at a position corresponding to each of second display areas DA2 (see FIG. 1) of the plurality of display panels 10. A size of the first opening portion 511 may be equal to or similar to a size of the second display area DA2 (see FIG. 1).

In an embodiment, the first opening portion 511 may have a circular shape corresponding to a shape of the second display area DA2 (see FIG. 1) illustrated in FIG. 1, but is not limited thereto. The first opening portion 511 may have a polygonal shape such as a quadrangular shape, a star shape, or an irregular shape according to the shape of the second display area DA2 (see FIG. 1).

The second mask 520 may be arranged on the first mask 510. In detail, the second mask 520 may be arranged on a surface of the first mask 510 opposite to the mask frame 530. The second mask 520 may be arranged to cover the first mask 510, in particular, the first opening portion 511. In an embodiment, the second mask 520 may be provided as a plurality of second masks 520, and when two or more second masks 520 are provided, the second masks 520 may be arranged on the first mask 510 to be parallel to each other. In this case, the second masks 520 may be arranged in one direction (e.g., an X-direction in FIG. 6). In an embodiment, the second mask 520 may be fixed to the first mask 510 by using welding.

The second mask 520 may include a second opening portion 521. In an embodiment, the second opening portion 521 is provided as a plurality of second opening portions 521 and may be formed over the entire surface of the second mask 520. Because the second opening portion 521 includes an area corresponding to the first opening portion 511 and is formed over the entire surface of the second mask 520, the second opening portion 521 is formed only in a specific area so that the possibility that the second mask 520 is deformed may be prevented.

In another embodiment, the second opening portion 521 is provided as a plurality of second opening portions 521 and may be formed in an area of the second mask 520 corresponding to the first opening portion 511. That is, the second opening portion 521 may be formed to be arranged only in the first opening portion 511 in a direction (e.g., the -Z direction in FIG. 6) perpendicular to one surface of the first mask 510. However, one or more embodiments are not limited thereto, and the second opening portion 521 may be formed adjacent to the first opening portion 511 to be arranged outside the first opening portion 511.

Hereinafter, for convenience of description, a case where the second opening portion 521 is formed over at least substantially the entire surface of the second mask 520 as illustrated in FIG. 6 will be mainly described.

The plurality of second opening portions 521 may be arranged to be at positions corresponding to the opening areas OA of the mask frame 530, that is, in the opening area OA when viewed in the -Z direction in FIG. 6. Also, some of the plurality of second opening portions 521 may overlap the first opening portions 511 in a direction (e.g., the -Z direction in FIG. 6) perpendicular to one surface of the first mask 510. That is, the plurality of second opening portions 521 may overlap in one first opening portion 511. In this case, a diameter or an area of the second opening portion 521 (e.g., a diameter or an area of a cross-section of the second opening portion 521 when viewed in a -Z direction in FIGS. 6 and 7) may be less than a diameter or an area of the first opening portion 511.

In an embodiment, the second opening portion 521 in an area overlapping the first opening portion 511 may be formed at a position corresponding to the transmission portion TA (see FIG. 3) of the second display area DA2 (see FIG. 1). A size of the second opening portion 521 may be equal to or similar to a size of the transmission portion TA (see FIG. 3). Accordingly, when the material to be deposited is deposited, the material to be deposited may sequentially pass through the opening area OA of the mask frame 530, the first opening portion 511 of the first mask 510, and the second opening portion 521 of the second mask 520 and may be deposited on the transmission portion TA (see FIG. 3) of the second area DA2 (see FIG. 1).

Referring to FIG. 8, an air channel 540 (see figure 6) through which air flows may be between the mask frame 530 and the first mask 510. The air channel 540 may be arranged in an area in which the first mask 510 and the mask frame 530 are in contact with each other. In an embodiment, the air channel 540 may be arranged along the outer circumference of the opening area OA. That is, the air channel 540 may be spaced apart from the first opening portion 511 and/or the second opening portion 521 and formed in the first mask 510 and/or the mask frame 530 along the outer circumference of the opening area OA.

As described above, the mask assembly 500 may be cleaned in a process of manufacturing a display apparatus. The air channel 540 forms a space in a contact area between the mask frame 530 and the first mask 510 and facilitates drying so that foreign materials such as a cleaning solution or the like may be prevented from remaining between the mask frame 530 and the first mask 510. Also, foreign materials such as a cleaning solution or the like may not be filled in the contact area between the mask frame 530 and the first mask 510 and may be easily discharged.

In an embodiment, the air channel 540 may include a first groove 541 formed in the first mask 510. The first groove 541 may be formed concavely in the first mask 510 in a thickness direction from one surface (e.g., a surface in -Z direction in FIG. 8) of the first mask 510 in contact with the mask frame 530. The first groove 541 may extend in a first direction (e.g., a Y-direction in FIG. 8) and may also extend in a second direction (e.g., an X-direction in FIG. 8) crossing the first direction. In an embodiment, the first groove 541 may be formed along the outer circumference of the first mask 510, that is, at all four corners of the first mask 510. However, in another embodiment, the first groove 541 may be formed only at one corner and an opposite corner of the first mask 510.

A portion of the first groove 541 may be positioned on the opening area OA, and another portion of the first groove 541 may be positioned on the mask frame 530, not on the opening area OA. That is, the first groove 541 may overlap the circumference of the opening area OA in a direction (e.g., a Z-direction in FIG. 8) perpendicular to one surface of the first mask 510. In this case, a surface of the mask frame 530 forming the opening area OA may be inclined. That is, the width of the mask frame 530 decreases from the surface of the mask frame 530 in contact with the first mask 510 toward an opposite surface, and accordingly, the surface of the mask frame 530 forming the opening area OA may be inclined.

A width w of the first groove 541 may be formed to be symmetrical with respect to the circumference of the opening area OA, in particular, the circumference of the opening area OA on the upper surface (e.g., a surface in the Z-direction in FIG. 8) of the mask frame 530.

In an embodiment, a thickness of the first mask 510 may be constant at a portion of the first mask 510 in which the first groove 541 is formed. That is, a first groove 541 having a certain height h may be formed in the first mask 510.

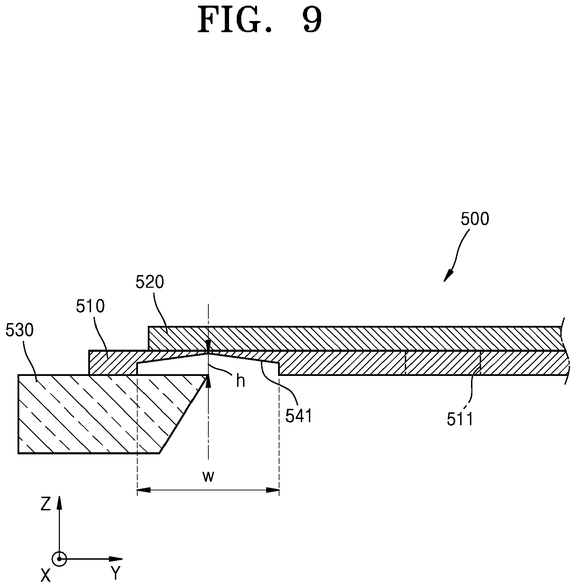

FIGS. 9 to 11 are cross-sectional views of the mask assembly 500 similar to FIG. 8 illustrating the mask assembly 500, according to an embodiment. Hereinafter, differences from the aforementioned embodiments are mainly described for sake of brevity.

Referring to FIGS. 9 to 11, the thickness of the first mask 510 may be different at the portion of the first mask 510 in which the first groove 541 is formed. That is, a first groove 541 having a different height h may be formed in the first mask 510.

In an embodiment, as illustrated in FIG. 9, the first groove 541 may be formed so that the height h increases toward the center thereof. In other words, the thickness of the first mask 510 may decrease toward the center of the first groove 541. Even in this case, the width w of the first groove 541 may be formed to be symmetrical with respect to the circumference of the opening area OA, in particular, the circumference of the opening area OA on the upper surface (e.g., the surface in the Z-direction in FIG. 8) of the mask frame 530.

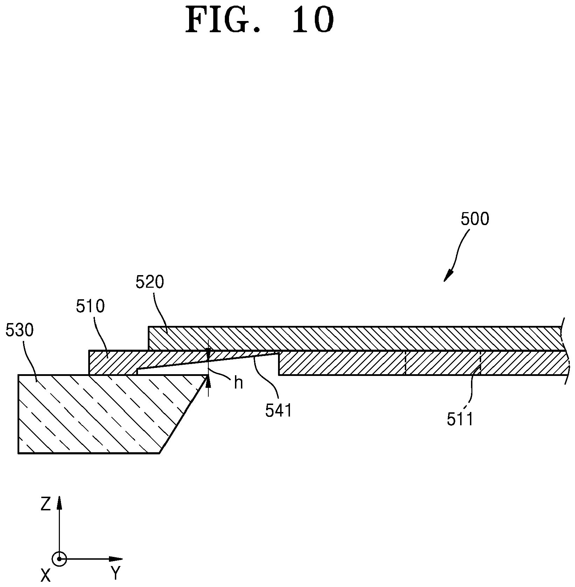

In another embodiment, as illustrated in FIG. 10, the first groove 541 may be formed so that the height h increases in one direction (e.g., a Y-direction in FIG. 10). The thickness of the first mask 510 may decrease from the first groove 541 toward the center of the opening area OA (e.g., in the Y-direction in FIG. 10).

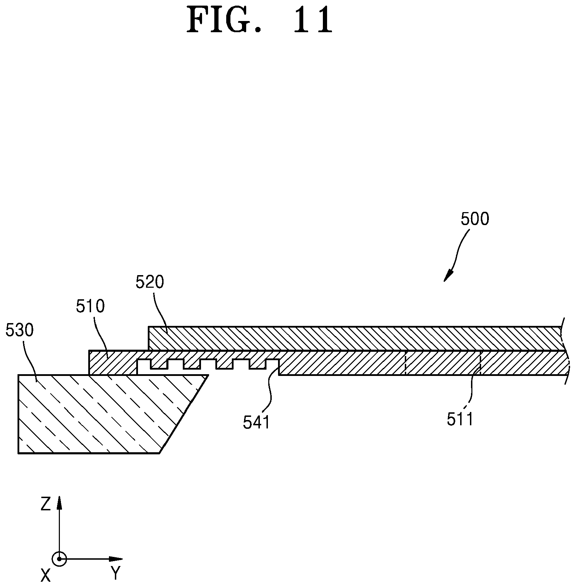

In another embodiment, as illustrated in FIG. 11, the first groove 541 may include uneven portions. That is, a convex portion and a concave portion (or castellated) may alternate toward the mask frame 530 inside the first groove 541. The convex portion and the concave portion may extend along the circumference of the opening area OA, that is, in an X-direction in FIG. 11. A length of the convex portion may be determined so that the convex portion is inside the first groove 541 and does not come into contact with the mask frame 530.

The length of the convex portion may be constant, but is not limited thereto. For example, the length of the convex portion may be formed to decrease from the first groove 541 toward the center of the opening area OA (e.g., in a Y-direction in FIG. 11).

The mask assembly 500 including the first groove 541 having such a shape may facilitate discharge of a cleaning solution when the mask assembly 500 is cleaned.

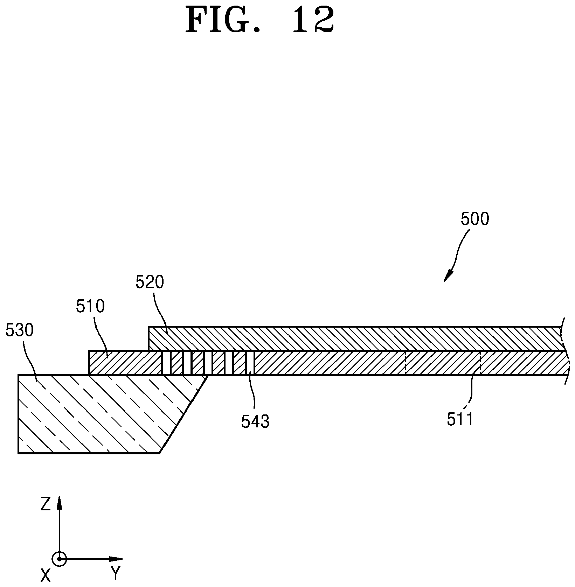

FIG. 12 is a diagram similar to FIG. 8 illustrating the mask assembly 500, according to another embodiment. Hereinafter, differences from the aforementioned embodiments are mainly described for sake of brevity.

Referring to FIG. 12, the air channel 540 may include a plurality of holes 543 passing through the first mask 510. The plurality of holes 543 may pass through the first mask 510 to form a space between the second mask 520 and the mask frame 530 or form a space between the second mask 520 and the opening area OA.

The plurality of holes 543 may be spaced apart from each other at regular intervals in a first direction (e.g., a Y-direction in FIG. 12). Also, the plurality of holes 543 may be spaced apart from each other in a second direction (e.g., an X-direction in FIG. 12) crossing the first direction. Though FIG. 12 illustrates five holes 543 spaced apart from each other in the Y-direction, one or more embodiments are not limited thereto.

In an embodiment, the plurality of holes 543 may be arranged adjacent to the circumference of the opening area OA. In detail, some of the plurality of holes 543 may be positioned on the opening area OA, and other portions thereof may be positioned on the mask frame 530, not on the opening area OA. Also, the plurality of holes 543 may be between one end (e.g., an end in a -Y direction in FIG. 12) of the first mask 510 and the first opening portion 511.

In an embodiment, the plurality of holes 543 may be positioned in the second mask 520 when viewed in a direction (e.g., a Z-direction in FIG. 12) perpendicular to one surface of the first mask 510. Accordingly, the plurality of holes 543 may open the second mask 520 and prevent a cleaning solution from remaining between the first mask 510 and the second mask 520.

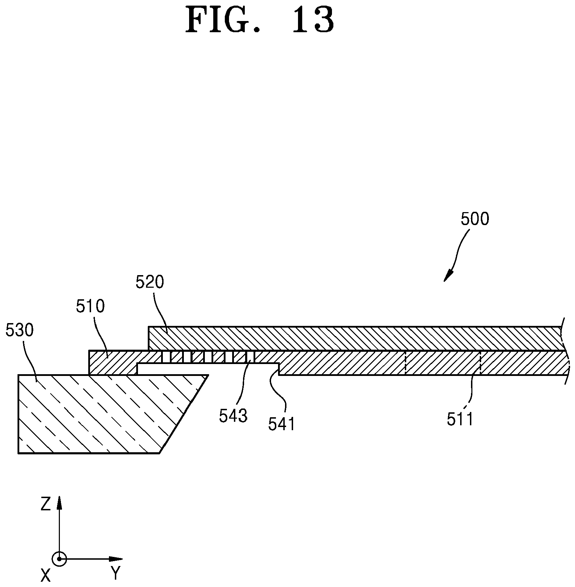

FIG. 13 is a diagram similar to FIG. 8 illustrating the mask assembly 500, according to another embodiment. Hereinafter, differences from the aforementioned embodiments are mainly described for sake of brevity.

Referring to FIG. 13, the air channel 540 may include a first groove 541 formed in the first mask 510. Also, the air channel 540 may include a hole 543 passing through the first mask 510 from the upper surface (e.g., a surface in a Z-direction in FIG. 13) of the first groove 541. In an embodiment, the hole 543 may be provided as a plurality of holes 543 and arranged to overlap the first groove 541. Similar to the above description, the plurality of holes 543 may be arranged on the first groove 541 to be spaced apart from each other in a first direction and a second direction crossing the first direction.

As described above, the first groove 541 may be formed in a portion of the first mask 510 in a thickness direction of the first mask 510, and the plurality of holes 543 may be formed in another portion of the first mask 510 in the thickness direction of the first mask 510. In an embodiment, the thickness of the first mask 510 in which the first groove 541 is formed may be equal to the thickness of the first mask 510 in which the plurality of holes 543 are formed.

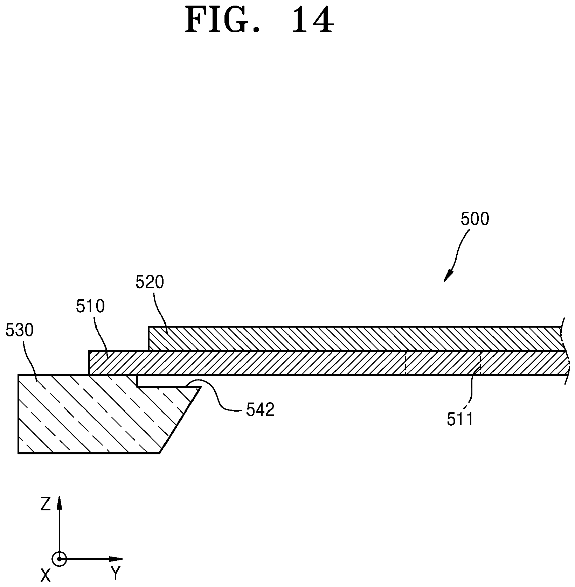

FIG. 14 is a diagram similar to FIG. 8 illustrating the mask assembly 500, according to another embodiment. Hereinafter, differences from the aforementioned embodiments are mainly described for sake of brevity.

Referring to FIG. 14, the air channel 540 may include a second groove 542 formed in the mask frame 530. The second groove 542 may be formed concavely in the mask frame 530 in a thickness direction from one surface (e.g., a surface in a Z-direction in FIG. 14) of the mask frame 530 in contact with the first mask 510. The second groove 542 may extend in a first direction (e.g., a Y-direction in FIG. 14) and may also extend in a second direction (e.g., an X-direction in FIG. 14) crossing the first direction. The second groove 542 may extend in a first direction and may be connected to the opening area OA. That is, the second groove 542 may have a shape opened toward the opening area OA. Accordingly, the mask frame 530 may have a shape having a step in a thickness direction.

Similar to the first groove 541 described above, the second groove 542 may be formed in the mask frame 530 along the circumference of the opening area OA. When viewed in a direction (e.g., the Z-direction in FIG. 14) perpendicular to one surface of the mask frame 530, for example, a surface of the mask frame 530 in contact with the first mask 510, the second groove 542 may overlap the first mask 510 and may have a shape surrounding the circumference of the opening area OA.

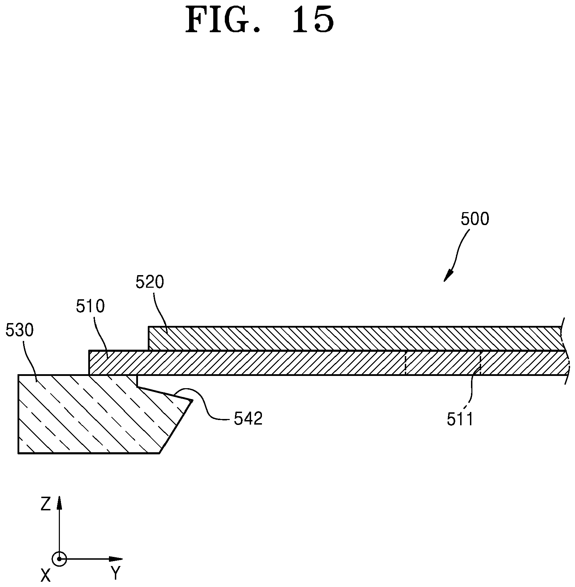

FIG. 15 is a diagram similar to FIG. 8 illustrating the mask assembly 500, according to another embodiment. Hereinafter, differences from the aforementioned embodiments are mainly described for sake of brevity.

Referring to FIG. 15, a thickness of the mask frame 530 may be different at a portion of the mask frame 530 in which the second groove 542 is formed. The thickness of the mask frame 530 may decrease toward the opening area OA. That is, one surface (e.g., a surface in a -Z direction in FIG. 15) of the second groove 542 may be inclined toward the opening area OA.

The mask assembly 500 including the second groove 542 having such a shape may facilitate discharge of a cleaning solution when the mask assembly 500 is cleaned.

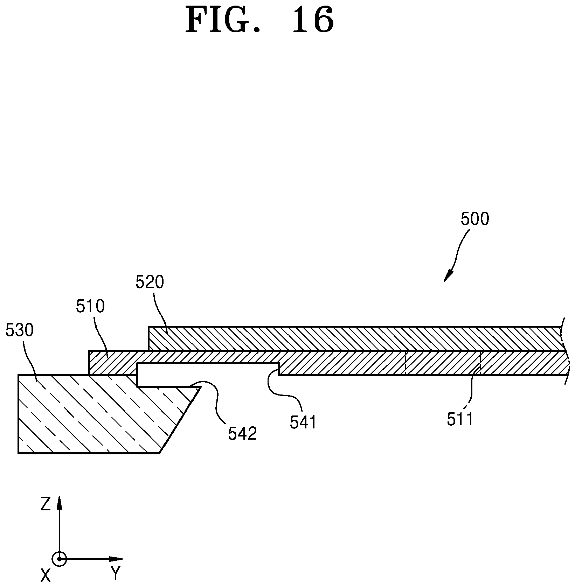

FIG. 16 is a diagram similar to FIG. 8 illustrating the mask assembly 500, according to another embodiment. Hereinafter, differences from the aforementioned embodiments are mainly described for sake of brevity.

Referring to FIG. 16, the air channel 540 may include a first groove 541 formed in the first mask 510 and a second groove 542 formed in the mask frame 530. That is, the mask assembly 500 may be a mask assembly 500 in which the mask assembly 500 in FIG. 8 and the mask assembly 500 in FIG. 14 are combined.

In this case, one end of the first groove 541 and one end of the second groove 542 in a width direction (e.g., a -Y direction in FIG. 16) may be in contact with each other. That is, when viewed in a direction (e.g., a -Z direction in FIG. 16) perpendicular to a contact surface of the first mask 510 and the mask frame 530, one end of the first groove 541 may overlap one end of the second groove 542.

The mask assembly 500 having such a shape may further facilitate discharge of a cleaning solution when the mask assembly 500 is cleaned. Also, though FIG. 16 illustrates a mask assembly in which the first groove 541 and the second groove 542 are combined, one or more embodiments are not limited thereto. For example, various combinations, such as a mask assembly in which the plurality of holes 543 and the second groove 542, are combined may be made.

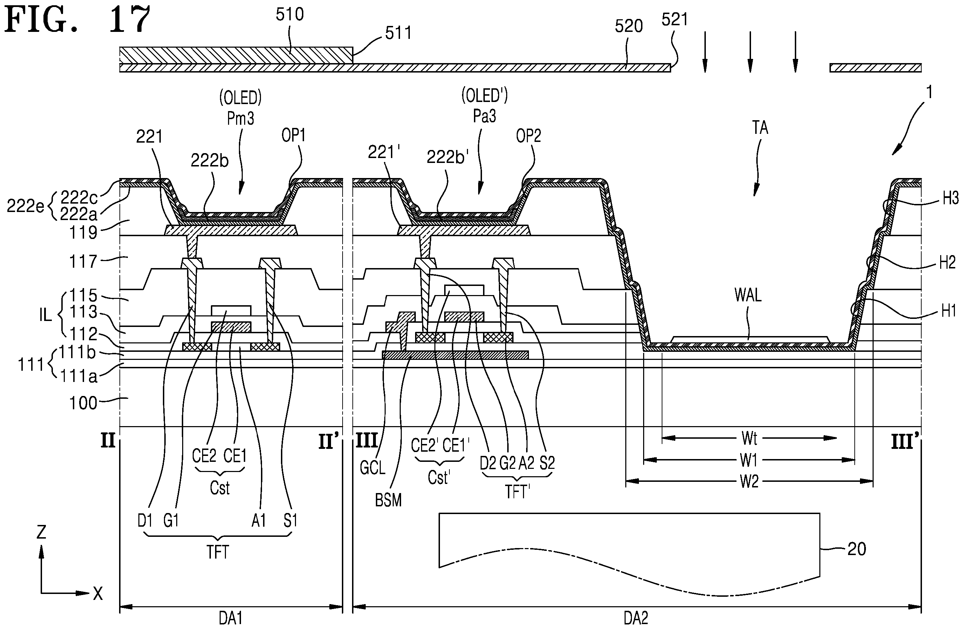

FIGS. 17 to 19 are schematic cross-sectional views of a method of manufacturing a display apparatus, according to an embodiment. In detail, FIGS. 17 to 19 illustrate an example of a patterning method of an opposite electrode, for example, a metal self-patterning (MSP) method, according to an embodiment. The method of manufacturing the display apparatus in the embodiment may be a method for manufacturing the display apparatus 1 described above.

A material to be deposited forming the opposite electrode 223 has a characteristic that a deposition result varies depending on a surface on which the material to be deposited is to be deposited. For example, from among materials forming the opposite electrode 223, Mg is difficult to form a film at an interface cleaned with some solvents such as methanol (MeOH), an interface between an HIL and an HTL, which may be included in the first functional layer 222a, or the like, and is also difficult to form a film even on a material forming the pixel-defining layer 119. Such a characteristic of Mg may be used as a patterning technique for the opposite electrode 223 itself.

Referring to FIG. 17, before the opposite electrode 223 is formed, a weak adhesion layer WAL is formed to correspond to the transmission portion TA. For example, the weak adhesion layer WAL may be formed on the upper surface of the second functional layer 222c inside the first hole H1 of the inorganic insulating layer IL.

The weak adhesion layer WAL may be formed to correspond to the transmission portion TA by using the mask assembly 500 having an area in which the first opening portion 511 of the first mask 510 and the second opening portion 521 of the second mask 520, which are described above, overlap each other. In detail, the first opening portion 511 may be opened to correspond to the second display area DA2, and the second opening portion 521 may be opened to correspond to the transmission portion TA. A material to be deposited forming the weak adhesion layer WAL may be formed in the transmission portion TA through the opening area OA of the mask frame 530, the first opening portion 511 of the first mask 510, and the second opening portion 521 of the second mask 520 in the apparatus 400 for manufacturing the display apparatus.

The weak adhesion layer WAL, which is a material having weak adhesion to the opposite electrode 223, may be a material having a characteristic in which the opposite electrode 223 is not formed or is formed very thinly on the upper surface of the weak adhesion layer WAL.

For example, the weak adhesion layer WAL may be formed by using a material such as 8-quinolinatolithium ([8-quinolinolato lithium] (Liq)), N,N-diphenyl-N,N-bis(9-phenyl-9H-carbazol-3-yl)biphenyl-4,4'-diamine (N,N-diphenyl-N,N-bis(9- phenyl-9H-carbazol-3-yl)biphenyl-4,4'-diamine (HT01)), N(diphenyl-4-yl)9,9-dimethyl-N-(4(9-phenyl-9H-carbazol-3-yl)phenyl)-9H-fluoren-2-amine (N(diphenyl-4 -yl)9,9-dimethyl-N-(4(9-phenyl-9H-carbazol-3-yl)phenyl)-9H-fluorene-2-amine (HT211)), 2-(4-(9,10-di(naphthalen-2-yl)anthracen-2-yl)phenyl)-1-phenyl-1H-benzo-[D]imidazole (2-(4-(9,10) -di(naphthalene-2-yl)anthracene-2-yl)phenyl)-1-phenyl-1H-benzo-[D]imidazole (LG201)), etc.

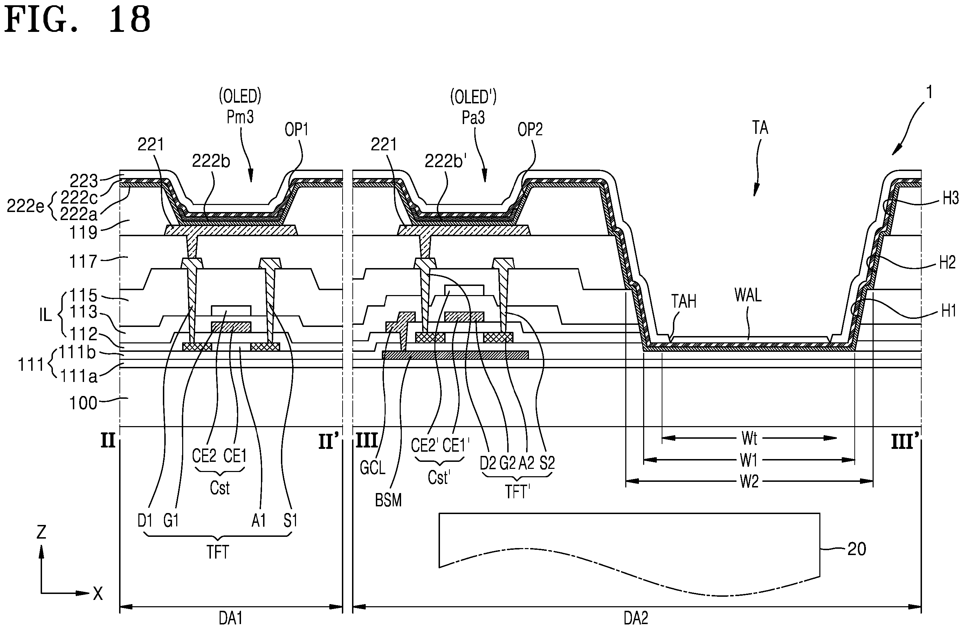

Next, referring to FIG. 18, the opposite electrode 223 is formed over the entire surface of the first display area DA1 and the second display area DA2 by using a completely open mask on the weak adhesion layer WAL.

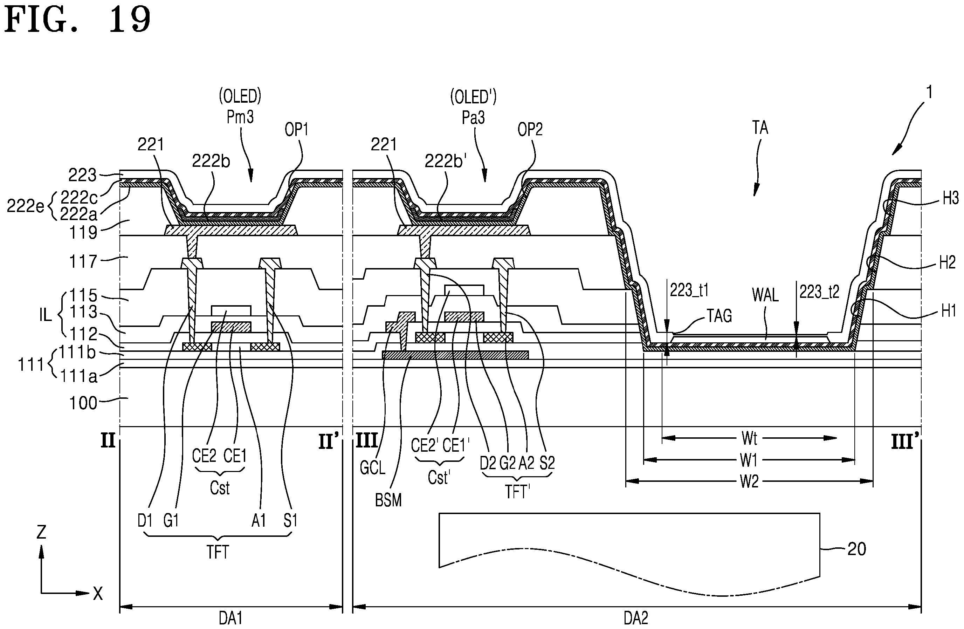

Because the material to be deposited for the opposite electrode 223 has weak adhesion to the weak adhesion layer WAL, as illustrated in FIG. 18, the opposite electrode 223 may be not formed on the upper surface of the weak adhesion layer WAL, and a transmission hole TAH may be formed. Alternatively, as illustrated in FIG. 19, the opposite electrode 223 may be formed very thinly on the weak adhesion layer WAL. That is, a thickness 223_t2 of the opposite electrode 223 on the weak adhesion layer WAL may be much less than a thickness 223_t1 of the opposite electrode 223 in a peripheral area of the weak adhesion layer WAL. In this case, the opposite electrode 223 may have a transmission groove TAG corresponding to the transmission portion TA.

A display panel in the embodiment may include the weak adhesion layer WAL arranged in the transmission portion TA, and the opposite electrode 223 including the transmission hole TAH or the transmission groove TAG corresponding to the transmission portion TA.

After the opposite electrode 223 is formed as described above, the upper layer 250 (see FIG. 4) and the encapsulation layer 300 may be sequentially formed to manufacture the display apparatus 1.

The apparatus 400 for manufacturing the display apparatus, in particular, the mask assembly 500 needs to be cleaned and dried for subsequent operations.

The apparatus 400 for manufacturing the display apparatus including the mask assembly 500, according to the aforementioned embodiments, may prevent a cleaning solution from remaining between the mask frame 530 and the first mask 510 or the second mask 520 when the mask assembly 500 is cleaned. The cleaning solution may be smoothly discharged through the air channel 540. Also, when the mask assembly 500 is dried, air flows through the air channel 540 so that drying may be facilitated.

According to one or more embodiments, a mask assembly that prevents residual foreign materials such as a cleaning solution or the like when a mask assembly is cleaned, and an apparatus and method for manufacturing a display apparatus may be provided. Accordingly, defects in a deposition process of a display apparatus due to the residual foreign materials may be prevented.

Although certain embodiments and implementations have been described herein, other embodiments and modifications will be apparent from this description. Accordingly, the inventive concepts are not limited to such embodiments, but rather to the broader scope of the invention as set out in the appended claims and various obvious modifications to the embodiments and equivalent arrangements as would be apparent to a person of ordinary skill in the art.

## Claims

1. A mask assembly comprising:
a mask frame that includes an opening area;
a first mask arranged on the mask frame and that includes at least one first opening portion in an area corresponding to the opening area; and
a second mask arranged on the first mask and that includes a plurality of second opening portions, wherein the plurality of second opening portions overlap the at least one first opening portion in a direction perpendicular to a surface of the first mask.

2. The mask assembly of claim 1, further comprising an air channel through which air flows, the air channel being between the mask frame and the first mask.

3. The mask assembly of claim 2, wherein the air channel is spaced apart from at least one of the at least one first opening portion and the plurality of second opening portions.

4. The mask assembly of claim 2 or 33, wherein the air channel is arranged in an area in which the8 mask frame is in contact with the first mask.

5. The mask assembly of claim 2, 3 or 4, wherein the air channel includes a groove concave toward inside the first mask in a thickness direction.

6. The mask assembly of claim 5, wherein one surface of the groove is inclined with respect to a surface of the mask frame facing the first mask.

7. The mask assembly of claim 5 or 6, wherein the thickness of the first mask gets thinner toward a center of the groove.

8. The mask assembly of claim 5, 6 or 7, wherein the groove overlaps an outer circumference of the opening area in the direction perpendicular to the surface of the first mask.

9. The mask assembly of any one of claims 2 to 8, wherein the air channel includes a plurality of holes passing through the first mask.

10. The mask assembly of claim 9, wherein, when viewed in the direction perpendicular to the surface of the first mask, the plurality of holes are overlapped with the second mask.

11. The mask assembly of claim 9, 10 or 11, wherein at least one of the plurality of holes is arranged to overlap an outer circumference of the opening area.

12. The mask assembly of any one of claims 2 to 11, wherein the air channel includes a groove and a hole, the groove being concave toward inside the first mask in a thickness direction, and the hole passing through the first mask from a surface of the groove.

13. The mask assembly of any one of claims 2 to 12, wherein the air channel includes a groove concave toward inside the mask frame in a thickness direction.

14. The mask assembly of claim 13, wherein one side of the groove is connected to the opening area.

15. The mask assembly of claim 13 or 14, wherein a thickness of the mask frame gets thinner from the groove toward the opening area.

16. The mask assembly of any one of claims 1 to 15, wherein a diameter of each of the plurality of second openings is less than a diameter of the at least one first opening portion.

17. An apparatus for manufacturing a display apparatus, the apparatus comprising:
a mask assembly arranged to face a substrate; and
a deposition source arranged to face the mask assembly,
wherein the mask assembly is as claimed in any one of claims 1 to 16.

18. A method of manufacturing a display apparatus, the method comprising:
arranging a display substrate in a chamber;
supplying a material to be deposited into the chamber by using a deposition source arranged in the chamber; and
depositing the material to be deposited on the display substrate through a mask assembly, the mask assembly being arranged to face the deposition source,
wherein the mask assembly is in accordance with any one of claims 1 to 16

19. The method of claim 18, further comprising:
cleaning the mask assembly; and
drying the mask assembly.
